(19) Europäisches Patentamt
European Patent Office
Office européen des brevets

(11) **EP 3 242 342 B1**

(12) **EUROPEAN PATENT SPECIFICATION**

(45) Date of publication and mention
of the grant of the patent:
**29.01.2020  Bulletin 2020/05**

(51) Int Cl.:
**H01L 51/52** *(2006.01)*      **H01L 27/32** *(2006.01)*
**H01L 51/56** *(2006.01)*

(21) Application number: **15875076.0**

(86) International application number:
**PCT/CN2015/097230**

(22) Date of filing: **14.12.2015**

(87) International publication number:
**WO 2016/107398 (07.07.2016 Gazette 2016/27)**

(54) **OLED DEVICE HAVING OPTICAL RESONANCE LAYER AND PREPARATION METHOD THEREFOR, AND DISPLAY DEVICE**

OLED-VORRICHTUNG MIT OPTISCHER RESONANZSCHICHT UND HERSTELLUNGSVERFAHREN DAFÜR UND ANZEIGEVORRICHTUNG

DISPOSITIF À DELO AYANT UNE COUCHE DE RÉSONANCE OPTIQUE, SON PROCÉDÉ DE PRÉPARATION ET DISPOSITIF D'AFFICHAGE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **31.12.2014  CN 201410846639**

(43) Date of publication of application:
**08.11.2017  Bulletin 2017/45**

(73) Proprietors:
• **Beijing Visionox Technology Co., Ltd.**
  **Beijing 100085 (CN)**
• **Kunshan New Flat Panel Display Technology Center Co. Ltd**
  **KunShan City, Jiangsu 215300 (CN)**

(72) Inventors:
• **LI, Mengzhen**
  **Beijing 100085 (CN)**
• **LIU, Song**
  **Beijing 100085 (CN)**
• **GAO, Song**
  **Beijing 100085 (CN)**
• **AO, Wei**
  **Kunshan**
  **Jiangsu 215300 (CN)**
• **ZHOU, Siran**
  **Kunshan**
  **Jiangsu 215300 (CN)**

(74) Representative: **Hanna Moore + Curley**
  **Garryard House**
  **25/26 Earlsfort Terrace**
  **Dublin 2, D02 PX51 (IE)**

(56) References cited:
EP-A1- 2 131 411       CN-A- 101 267 701
CN-A- 103 000 580      CN-A- 103 000 638
CN-A- 104 485 429      KR-A- 20090 112 090
US-A1- 2009 200 922    US-A1- 2009 251 051
US-A1- 2010 053 043    US-A1- 2014 312 325

## Description

## Technical Field

The present invention relates to the technical field of OLED display, and more particularly, to an OLED device with an optical resonance layer and fabrication method thereof, and a display device comprising the OLED device.

## Background Art

As the progress of science and technology, LCD (liquid crystal display) has gradually replaced the conventional bulky CRT (cathode ray tube), and has been widely applied to monitors, laptops, flat panel TVs, digital cameras and other electronic products, because of its advantages of small volume and light weight.

LCD needs LED (Light Emitting Diode) as the backlight light source. OLED (Organic Light Emitting Diode) display does not need a backlight module, and has the advantage of no visual angle limitation, so it is more suitable for the thin display, and has the tendency to replace the conventional CRT and LCD.

OLED displays have forms such as RGB displays and white light OLED+CF (Color Filter, Color Filter membrane), wherein the white light OLED+CF is a display technique that can realize large size and high resolution. However, white light will lose most of the light after passing through the CF, so the power consumption of the display screen is very high. Moreover, the color gamut of CF is low, and especially the color saturation of the green light is low, and the display effect is not good. How to improve the utilization rate of light to reduce the power consumption is a problem that urgently needs to be solved in white light OLED+CF technology.

In order to solve that problem, in the prior art, there is a solution of increasing white light pixels, that is, RGBW four pixels are adopted to reduce the power consumption, and there is also a solution that uses quantum dots light conversion layer to improve the conversion efficiency. However, those solutions are not ideal. In the prior art, there is also a technical solution that uses a uniform light scattering layer, but, in that solution, the extraction effect of part of light spectral band is not obvious. There is also another solution where different light resonance layers are used for R/G/B sub-pixels, but the process of the technical solution is very difficult and of high cost, and difficult to achieve the commercial application.

Each of patent specifications US 2009/251051 A1, US 2010/053043 A1 and US 2014/312325 A1 discloses an organic light emitting diode display, and more particularly, an organic light emitting diode display including a white emission layer and a color filter layer. Patent specification EP 2 131 411 A1 discloses an organic light emitting diode display device which can improve brightness and color coordinate characteristics in all emission wavelength ranges, and thus can enhance light extraction efficiency and color reproducibility. Patent specification US 2009/200922 A1 discloses an organic light emitting diode display including a white emission layer and a color filter layer and wherein a microcavity structure is only formed in the green sub-pixel.

## Summary

The technical problems to be solved by the present invention are to provide an OLED device with an optical resonance layer of high light efficiency, wide color gamut and low cost, and fabricating method thereof, and a display device comprising the OLED device.

To solve the above technical problems, the present invention provides an OLED device with an optical resonance layer as recited in claim 1.

Optionally, a thickness of the optical resonance layer enables optical paths from a reflection electrode to each of interfaces of the medium layer to meet an interference enhancement formula: $L = (2n + 1)\lambda/4$, wherein: L is the optical path from the reflection electrode to one of the interfaces of the medium layer, n is a natural number, and $\lambda$ is a central wavelength of filtered light.

The present invention also provides a display device comprising the above OLED device with an optical resonance layer.

The present invention also provides a method for fabricating an OLED device with an optical resonance layer as recited in claim 4.

The advantage of the present invention is that: By providing the optical resonance layer, the OLED device with an optical resonance layer provided by the present invention can filter monochromatic lights with good chromaticity and high efficiency, even by using a color filter film with a low color gamut, and specially, the problem of the low display quality in white light OLED+CF technology at present is solved. In addition, the OLED device provided by the present invention also greatly reduces the power consumption. Moreover, there is no need to use a fine metal mask (FMM), thereby reducing the processing cost.

## Brief Description of the Drawings

Figure 1 is a structural schematic diagram of the embodiment of an OLED device with an optical resonance layer according to the present invention.

Figure 2 is a structural schematic diagram of an example of an OLED device with an optical resonance layer not according to the present invention.

Figure 3 is a structural schematic diagram of another example of an OLED device with an optical resonance layer not according to the present invention.

In the drawings, 1 indicates a reflection electrode, 2 indicates a white light OLED, 3 indicates a transparent electrode, 4 indicates an optical resonance layer, 41 indicates a second medium layer, 42 indicates a first medium layer, 4' indicates a filling layer, 5 indicates a flat layer, and 6 indicates a color filter film.

## Detailed Description of the Preferred Embodiments

In the following, the present invention will be described in further detail with reference to the drawings and the detailed embodiments, in order to enable those skilled in the art to better understand and implement the present invention, but the present invention is not limited to the illustrated embodiments. The protection scope of the present invention is defined in the claims.

The OLED device with an optical resonance layer according to the present invention comprises a white light OLED and a color filter film (CF), so as to form an R sub-pixel (red sub-pixel), a G sub-pixel (green sub-pixel), a B sub-pixel (blue sub-pixel) and a W sub-pixel (white sub-pixel), and an optical resonance layer is disposed only in the region corresponding to the G sub-pixel between the white light OLED and the CF.

According to an example not according to the invention, the optical resonance layer may also be a composite medium layer comprising a first medium layer and a second medium layer, wherein the first medium layer is close to the color filter film, the second medium layer is located on the first medium layer, and a refractive index of the first medium layer is higher than that of the second medium layer.

Preferably, the refractive index of the second medium layer is 1-1.6, and the refractive index of the first medium layer is at least 0.2 higher than the refractive index of the second medium layer.

The thickness of the optical resonance layer enables optical paths from a reflection electrode to each of interfaces of the medium layers to meet an interference enhancement formula: $L = (2n + 1)\lambda/4$, wherein: L is the optical path from the reflection electrode to one of the interfaces of the medium layers, n is a natural number, and $\lambda$ is a central wavelength of filtered light. Generally, a thickness of the first medium layer is 10-150nm, and a thickness of the second medium layer is 0-300nm. When the thickness of the second medium layer is 0, that denotes that the optical resonance layer is a single-layer structure, that is, the optical resonance layer only consists of the first medium layer, which is according to the invention. At this time, the refractive index of the first medium layer is higher than the refractive index of the transparent electrode of the white light OLED that is in contact with the first medium layer.

In addition, in an example not according to the invention, an optical resonance layer may also be arranged in the regions corresponding to the R sub-pixel, the B sub-pixel and the W sub-pixel between the white light OLED and the CF. That is, besides the G sub-pixel, optical resonance layers may also be arranged for other color sub-pixels according to need. The optical resonance layer may be arranged in one or in any two selected from the regions corresponding to the R sub-pixel, the B sub-pixel and the W sub-pixel. Of course, the optical resonance layers may also be arranged in three regions. The optical resonance layers of other color sub-pixels may be the same as that of the G sub-pixel, and may be different.

A method for fabricating an OLED device with an optical resonance layer according to the present invention comprises the following steps:

cleaning a substrate, and fabricating a TFT array on the substrate,
fabricating a color filter film,
fabricating a flat layer on the color filter film,
fabricating the optical resonance layer on the flat layer of the color filter film corresponding to the region of a G sub-pixel and fabricating a filling layer in the other regions,
fabricating a transparent electrode on the optical resonance layer and the filling layer,
fabricating a white light OLED and a reflection electrode on the transparent electrode, and packaging to complete the fabricating of the OLED device.

The present invention will be explained by the detailed description of the embodiment.

The embodiment:

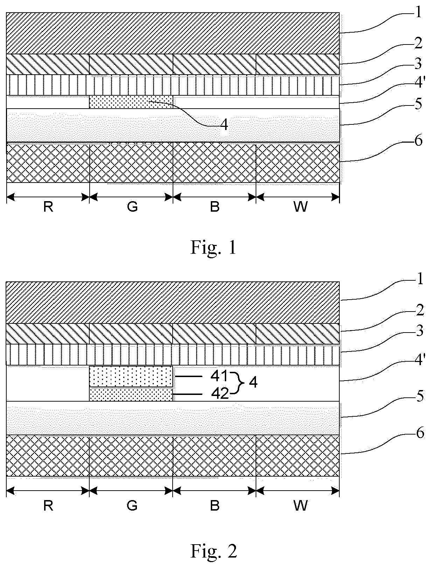

As shown in Figure 1, an OLED device with an optical resonance layer according to the embodiment comprises: a substrate, a TFT array (not shown in the figure) disposed on the substrate, and a color filter film 6 on the TFT array, wherein the color filter film 6 is divided into four colors of R, G, B and W, so as to filter the white light emitted by the white light OLED, to form an R sub-pixel, a G sub-pixel, a B sub-pixel and a W sub-pixel. The R sub-pixel, the G sub-pixel, the B sub-pixel and the W sub-pixel can emit lights with different intensities according to need, and the lights emitted by the R sub-pixel, the G sub-pixel, the B sub-pixel and the W sub-pixel are mixed to obtain the required color, so as to realize color display. A plurality of the OLED devices are arranged according to a certain rule (such as an array), and cooperate with a casing and other components to form the display device of the present invention

In the embodiment shown in Figure 1, a flat layer 5 is arranged on the color filter film 6, and an optical resonance layer 4 is arranged on the flat layer 5, wherein the optical resonance layer 4 exists only in the region corresponding to the G sub-pixel. In this embodiment, the optical resonance layer 4 is a single-layer medium structure, that is, it has only a first medium layer. A transparent electrode 3 is formed on the optical resonance layer 4, and the refractive index of the optical resonance layer 4 is higher than the refractive index of the transparent electrode 3. A white light OLED 2 and a reflection electrode 1 are arranged on the transparent electrode 3, and an OLED device is formed by packaging. A filling layer 4' is provided in a region without the optical resonance layer to fill the gap. The material of the filling layer 4' may be the same as that of the flat layer 5.

The method for fabricating the OLED device in the embodiment is as follows:

1. cleaning the substrate, and fabricating the TFT array on the substrate,
2. fabricating the color filter film 6,
3. fabricating the flat layer 5 on the color filter film 6,
4. fabricating the single-layer optical resonance layer 4 on the flat layer 5 of the color filter film corresponding to the region of a G sub-pixel, and fabricating the filling layer 4' in the other regions,
5. fabricating the transparent electrode 3 on the optical resonance layer 4 and the filling layer 4',
6. fabricating the white light OLED 2 and the reflection electrode 1 on the transparent electrode 3, and
7. packaging to complete the fabricating of the OLED device of the embodiment.

First example not according to the invention:

As shown in Figure 2, the difference between this example and the embodiment is that the optical resonance layer 4 is a double-layer medium structure. That is, the optical resonance layer 4 of the first example comprises a first medium layer 42 and a second medium layer 41.

The method for fabricating the OLED device of the first example is as follows:

1. cleaning the substrate, and fabricating the TFT array on the substrate,
2. fabricating the color filter film 6,
3. fabricating the flat layer 5 on the color filter film 6,
4. fabricating the first medium layer 42 on the flat layer 5 of the color filter film corresponding to the region of a G sub-pixel, and fabricating the second medium layer 41 on the first medium layer 42, to complete the fabricating of the optical resonance layer 4 with a double medium layer structure, and fabricating the filling layer 4' in the other regions,
5. fabricating the transparent electrode 3 on the optical resonance layer 4 and the filling layer 4',
6. fabricating the white light OLED 2 and the reflection electrode 1 on the transparent electrode 3, and
7. packaging to complete the fabricating of the OLED device of the first example.

The second example not according to the invention:

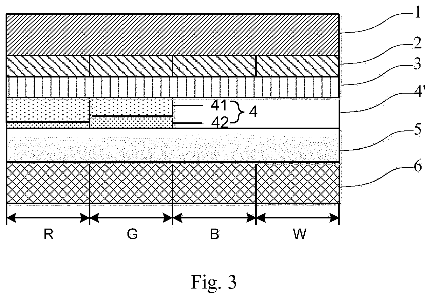

As shown in figure 3, the difference between this second example and the embodiment is that the optical resonance layer 4 is also arranged in the region of the R sub-pixel, besides the region of the G sub-pixel, and the optical resonance layers 4 in the two regions are both double-layer medium structures. That is, the optical resonance layers 4 of the second example comprise a first medium layer 42 and a second medium layer 41. Further, the material of the optical resonance layer in the G sub-pixel region is different from that of the optical resonance layer in the R sub-pixel region.

The method for fabricating the OLED device of the second example is as follows:

1. cleaning the substrate, and fabricating the TFT array on the substrate,
2. fabricating the color filter film 6,
3. fabricating the flat layer 5 on the color filter film 6,
4. fabricating the first medium layers 42 on the flat layer 5 of the color filter film corresponding to the region of a G sub-pixel and the R sub-pixel, respectively, and fabricating the second medium layers 41 on the first medium layers 42, to complete the fabricating of the optical resonance layers 4 with a double medium layer structure, wherein the thicknesses of each medium layer of the resonance layers corresponding to the R sub-pixel and the G sub-pixel are respectively the thickness of the interference enhancement of filtered light by the R sub-pixel and the G sub-pixel, and fabricating the filling layer 4' in the other regions,
5. fabricating the transparent electrode 3 on the optical resonance layers 4 and the filling layer 4',
6. fabricating the white light OLED 2 and the reflection electrode 1 on the transparent electrode 3, and
7. packaging to complete the fabricating of the OLED device of the second example.

The OLED device enhances the extraction of the monochromatic lights, reduces the power consumption, improves the color quality, reduces the requirements on the CF, and meanwhile has no need to dispose a precision evaporation mask plate.

The material of the first medium layer may choose ITO, ZTO, $TiO_2$, $SiN_x$, NiO, MgO, $SnO_3$, ZnO, ZnS or ZnSe. The material of the second medium layer may choose ITO, $SiO_x$, $Al_2O_3$ or ZTO.

The advantageous effects of the present invention will be explained with the experimental data, and the experimental method adopts the commonly used method for measuring light efficiency in this field.

Comparative example: there is no medium layer material. The experimental results show that the green light efficiency is 18.09cd/A, CIE (0.26, 0.63), and the red light efficiency is 12.96cd/A, CIE (0.65, 0.34).

Example 1 according to the invention (its structure is as shown in Figure 1): The material of the first medium layer in the green light region is $SiN_x$, and the thickness is 10nm. The thickness of the second medium layer is 0nm, that is, a single medium layer structure is adopted only comprising the first medium layer. The experimental results show that the green light efficiency is 23.54cd/A, CIE (0.24, 0.65). The efficiency and chromaticity of green light have been improved, and the other regions are the same as the comparative example.

Example 2 according to the invention (its structure is as shown in Figure 1): The material of the first medium layer in the green light region is $SiN_x$, and the thickness is 70nm. The thickness of the second medium layer is 0nm, that is, a single medium layer structure is adopted only comprising the first medium layer. The experimental results show that the green light efficiency is 25.54cd/A, CIE (0.23, 0.65). The efficiency and chromaticity of green light have been improved, and the other regions are the same as the comparative example.

Example 3 according to the invention (its structure is as shown in Figure 1): The material of the first medium layer in the green light region is $SiN_x$, and the thickness is 150nm. The thickness of the second medium layer is 0nm, that is, a single medium layer structure is adopted only comprising the first medium layer. The experimental results show that the green light efficiency is 28.54cd/A, CIE (0.23, 0.64). The efficiency and chromaticity of green light have been improved, and the other regions are the same as the comparative example.

Example 4 not according to the invention (its structure is as shown in Figure 2): The material of the first medium layer in the green light region is $SiN_x$, and the thickness is 50nm. The material of the second medium layer is $SiO_x$, and the thickness is 10nm. The experimental results show that the green light efficiency is 25.54cd/A, CIE (0.23, 0.64). The efficiency and chromaticity of green light have been improved, and the other regions are the same as the comparative example.

Example 5 not according to the invention (its structure is as shown in Figure 2): The material of the first medium layer in the green light region is $SiN_x$, and the thickness is 50nm. The material of the second medium layer is $SiO_x$, and the thickness is 120nm. The experimental results show that the green light efficiency is 34.9cd/A, CIE (0.21, 0.69). The efficiency and chromaticity of green light have been improved, and the other regions are the same as the comparative example.

Example 6 not according to the invention (its structure is as shown in Figure 3): The material of the first medium layer in the green light region is $SiN_x$, and the thickness is 50nm. The material of the second medium layer is $SiO_x$, and the thickness is 10nm. The experimental results show that the green light efficiency is 25.54cd/A, CIE (0.23, 0.64). The material of the first medium layer in the red light region is $SiN_x$, and the thickness is 50nm. The material of the second medium layer is $SiO_x$, and the thickness is 160nm. The experimental results show that the red light efficiency is 16.16cd/A, CIE (0.66, 0.34).The efficiency and chromaticity of green light and red light have both been improved, and the other regions are the same as the comparative example.

Example 7 not according to the invention (its structure is as shown in Figure 2): The material of the first medium layer in the green light region is $SiN_x$, and the thickness is 50nm. The material of the second medium layer is $SiO_x$, and the thickness is 300nm. The experimental results show that the green light efficiency is 27.3cd/A, CIE (0.25, 0.67). The efficiency and chromaticity of green light have been improved, and the other regions are the same as the comparative example.

The above examples 1 to 3 according to the invention are merely preferable examples, in order to fully explain the present invention, and the scope of the present invention is not limited thereto. The protection scope of the present invention is defined in the claims.

## Claims

1.  An OLED device having an optical resonance layer (4), comprising: a white light OLED (2) and a color filter film (6), so as to form a red (R) sub-pixel, a green (G) sub-pixel, a blue (B) sub-pixel and a white (W) sub-pixel, wherein the optical resonance layer (4) is disposed only in a region corresponding to the green sub-pixel between the white light OLED (2) and the color filter film (6), wherein a flat layer (5) is arranged on the color filter film (6), and the optical resonance layer (4) is arranged on the flat layer (5), wherein the optical resonance layer (4) is a single-layer medium structure having only a first medium layer (42), wherein a transparent electrode (3) is disposed on the optical resonance layer (4), and the white light OLED (2) and a reflection electrode (1) are disposed on the transparent electrode (3), **characterized in that** the refractive index of the optical resonance layer (4) is higher than the refractive index of the transparent electrode (3), and a filling layer (4') is disposed between the flat layer (5) and the transparent electrode (3) in the same plane as the optical resonance layer (4) parallel to the flat layer (5) to fill a gap in the regions without the optical resonance layer (4).

2.  The OLED device with an optical resonance layer (4) as claimed in claim 1, wherein a thickness of the optical resonance layer (4) enables optical paths from a reflection electrode to each of interfaces of the medium layer to meet an interference enhancement formula: $L=(2n+1)\lambda/4,$ wherein: L is the optical path from the reflection electrode to one of the interfaces of the medium layer, n is a natural number, and λ is a central wavelength of filtered light.

3. A display device comprising the OLED device with an optical resonance layer (4) as claimed in any one of claims 1 to 2.

4. A method for fabricating an OLED device with a single-layer optical resonance layer (4) as defined in claim 1, comprising the steps of:

cleaning a substrate, and fabricating a TFT array on the substrate,
fabricating a color filter film (6),
fabricating a flat layer (5) on the color filter film (6),
fabricating the single-layer optical resonance layer (4) on the flat layer (5) of the color filter film (6) corresponding to the region of a green (G) sub-pixel, and fabricating a filling layer (4') in the other regions,
fabricating a transparent electrode (3) on the optical resonance layer (4) and the filling layer (4'),
fabricating a white light OLED (2) and a reflection electrode (1) on the transparent electrode (3), and packaging to complete the fabricating of the OLED device.

**Patentansprüche**

1. OLED-Vorrichtung, die eine optische Resonanzschicht (4) aufweist, umfassend: eine Weißlicht-OLED (2) und einen Farbfilterfilm (6), um ein rotes (R) Subpixel, ein grünes (G) Subpixel, ein blaues (B) Subpixel und ein weißes (W) Subpixel zu bilden, wobei die optische Resonanzschicht (4) nur in einem Bereich angeordnet ist, der dem grünen Subpixel zwischen der Weißlicht-OLED (2) und dem Farbfilterfilm (6) entspricht, wobei eine flache Schicht (5) auf dem Farbfilterfilm (6) angeordnet ist und die optische Resonanzschicht (4) auf der flachen Schicht (5) angeordnet ist, wobei die optische Resonanzschicht (4) eine einschichtige mittlere Struktur ist, die nur eine erste mittlere Schicht (42) aufweist, wobei eine transparente Elektrode (3) auf der optischen Resonanzschicht (4) angeordnet ist und eine Weißlicht-OLED (2) und eine Reflexionselektrode (1) auf der transparenten Elektrode (3) angeordnet sind, **dadurch gekennzeichnet, dass** der Brechungsindex der optischen Resonanzschicht (4) höher ist als der Brechungsindex der transparenten Elektrode (3) und eine Füllschicht (4') zwischen der flachen Schicht (5) und der transparenten Elektrode (3) in der gleichen Ebene wie die optische Resonanzschicht (4) parallel zu der flachen Schicht (5) angeordnet ist, um eine Lücke in den Bereichen ohne die optische Resonanzschicht (4) zu füllen.

2. OLED-Vorrichtung mit einer optischen Resonanzschicht (4) nach Anspruch 1, wobei eine Dicke der optischen Resonanzschicht (4) optische Wege von einer Reflexionselektrode zu jeder von Schnittstellen der mittleren Schicht ermöglicht, um eine Interferenzverbesserungsformel zu erfüllen:

$$L = (2n+1)\lambda/4,$$

wobei: L der optische Weg von der Reflexionselektrode zu einer der Schnittstellen der mittleren Schicht ist, n eine natürliche Zahl ist und λ eine Mittenwellenlänge von gefiltertem Licht ist.

3. Anzeigevorrichtung, umfassend die OLED-Vorrichtung mit einer optischen Resonanzschicht (4) nach einem der Ansprüche 1 bis 2.

4. Verfahren zum Herstellen einer OLED-Vorrichtung mit einer einschichtigen optischen Resonanzschicht (4) nach Anspruch 1, umfassend die Schritte:

Reinigen eines Substrats und Herstellen einer TFT-Anordnung auf dem Substrat,
Herstellen eines Farbfilterfilms (6),
Herstellen einer flachen Schicht (5) auf dem Farbfilterfilm (6),
Herstellen der einschichtigen optischen Resonanzschicht auf der flachen Schicht (5) des Farbfilterfilms (6), die dem Bereich eines grünen (G) Subpixels entspricht, und Herstellen einer Füllschicht (4') in den anderen Bereichen,
Herstellen einer transparenten Elektrode (3) auf der optischen Resonanzschicht (4) und der Füllschicht (4'),
Herstellen einer Weißlicht-OLED (2) und einer Reflexionselektrode (1) auf der transparenten Elektrode (3) und
Verpacken, um das Herstellen der OLED-Vorrichtung abzuschließen.

**Revendications**

1. Dispositif DELO ayant une couche de résonance optique (4), comprenant : une DELO à lumière blanche (2) et un film de filtre coloré (6), de façon à former un sous-pixel rouge (R), un sous-pixel vert (G), un sous-pixel bleu (B) et un sous-pixel blanc (W), dans lequel la couche de résonance optique (4) est disposée uniquement dans une région correspondant au sous-pixel vert entre la DELO à lumière blanche (2) et le film de filtre coloré (6), dans lequel une couche plate (5) est agencée sur le film de filtre coloré (6), et la couche de résonance optique (4) est agencée sur la couche plate (5), dans lequel la couche de résonance optique (4) est une structure à milieu monocouche ayant uniquement une première couche de milieu (42), dans lequel une électrode transparente (3) est disposée sur la couche de résonance optique (4), et la DELO à lumière blanche (2) et une électrode de réflexion (1) sont disposées sur l'électrode transparente (3),

**caractérisé par le fait que** l'indice de réfraction de la couche de résonance optique (4) est supérieur à l'indice de réfraction de l'électrode transparente (3), et une couche de remplissage (4') est disposée entre la couche plate (5) et l'électrode transparente (3) dans le même plan que la couche de résonance optique (4) parallèle à la couche plate (5) pour remplir un intervalle dans les régions exemptes de la couche de résonance optique (4).

2. Dispositif DELO ayant une couche de résonance optique (4) selon la revendication 1, dans lequel une épaisseur de la couche de résonance optique (4) permet à des trajets optique depuis une électrode de réflexion vers chacune des interfaces de la couche de milieu de satisfaire une formule d'amélioration d'interférence : $L=(2n+1)\lambda/4$, dans laquelle : L est le trajet optique depuis l'électrode de réflexion vers l'une des interfaces de la couche de milieu, n est un entier naturel et $\lambda$ est une longueur d'onde centrale de lumière filtrée.

3. Dispositif d'affichage comprenant le dispositif DELO ayant une couche de résonance optique (4) selon l'une quelconque des revendications 1 à 2.

4. Procédé de fabrication d'un dispositif DELO ayant une couche de résonance optique monocouche (4) tel que défini à la revendication 1, comprenant les étapes suivantes :

   nettoyer un substrat, et fabriquer un réseau TFT sur le substrat,
   fabriquer un film de filtre coloré (6),
   fabriquer une couche plate (5) sur le film de filtre coloré (6),
   fabriquer la couche de résonance optique monocouche (4) selon sur la couche plate (5) du film de filtre coloré (6) correspondant à la région d'un sous-pixel vert (G), et fabriquer une couche de remplissage (4') dans les autres régions,
   fabriquer une électrode transparente (3) sur la couche de résonance optique (4) et la couche de remplissage (4'),
   fabriquer une DELO à lumière blanche (2) et une électrode de réflexion (1) sur l'électrode transparente (3), et
   mettre en boîtier pour achever la fabrication du dispositif DELO.

Fig. 1

Fig. 2

Fig. 3

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2009251051 A1
- US 2010053043 A1
- US 2014312325 A1
- EP 2131411 A1
- US 2009200922 A1